# EUROPEAN PATENT APPLICATION

(11) **EP 0 633 605 A2**
(43) Date of publication of application: **11.01.1995**
(21) Application number: 94109806.3
(22) Date of filing: 24.06.1994
(51) Int. Cl.: H01L 21/316, H01L 21/76

(54) **Thin film for semiconductor device and manufacturing method of thin film for semiconductor device**

(30) Priority: 25.06.1993 JP 155371/93
(71) Applicant: APPLIED MATERIALS, INC., Santa Clara California 95052-8039 (US)
(72) Inventor: Musaka, Katsuyuki, Sakae, Chiba 270-15 (JP); Mizuno, Shinsuke, c/o Applied Materials Japan, Narita-shi, Chiba-ken (JP)
(74) Representative: Kahler, Kurt, Dipl.-Ing.

(57) **Abstract**

Purpose: To realize a type of thin film with excellent embedding characteristics, good control of thin film thickness, low dielectric constant, very low hygroscopicity, and excellent compressive stress.

Configuration: A first formation layer (L1) with excellent compressive stress is formed from the TEOS gas using the PECVD method; a second formation layer (L2) with a lower compressive stress yet excellent embedding characteristics, low dielectric constant, and other excellent properties is formed from a gas mixture of TEOS gas and halogen gas using the PECVD method; these first and second formation layers (L1, L2) are combined appropriately to form a laminate configuration made of several layers laminated to each other.

## Description

### Industrial application field

This invention concerns the configuration of a type of thin film of semiconductor device formed on semiconductor substrate or other sample surface by means of plasma enhanced CVD, as well as a manufacturing method of the thin film.

### Prior art

In the conventional method, in order to form a thin film on a sample surface, such as a semiconductor substrate, the plasma enhanced CVD method is usually used. In this method, a plasma is generated in the reaction container of a plasma enhanced CVD (referred to as PECVD hereinafter) apparatus, and the plasma discharge energy is used to activate the reaction gas, so that the deposit formed in the chemical vapor deposition of the reaction gas is coated on the sample surface to form the desired thin film.

In this method, the reaction gas used for coating a SiO₂ thin film on the surface of a semiconductor substrate may be SiH₄ gas (silane type gas) or TEOS (tetraethylorthosilicate) gas.

In the recent years, with development of the VLSI, semiconductor devices with even higher integration density, it becomes very important to develop the formation technology of fine patterns of the order of submicrons. In this case, by means of the experimental verification of the shape of the thin film formed using the conventional CVD method, the possibility in using the conventional technology in the formation of submicron fine pattern of semiconductor device has been studied.

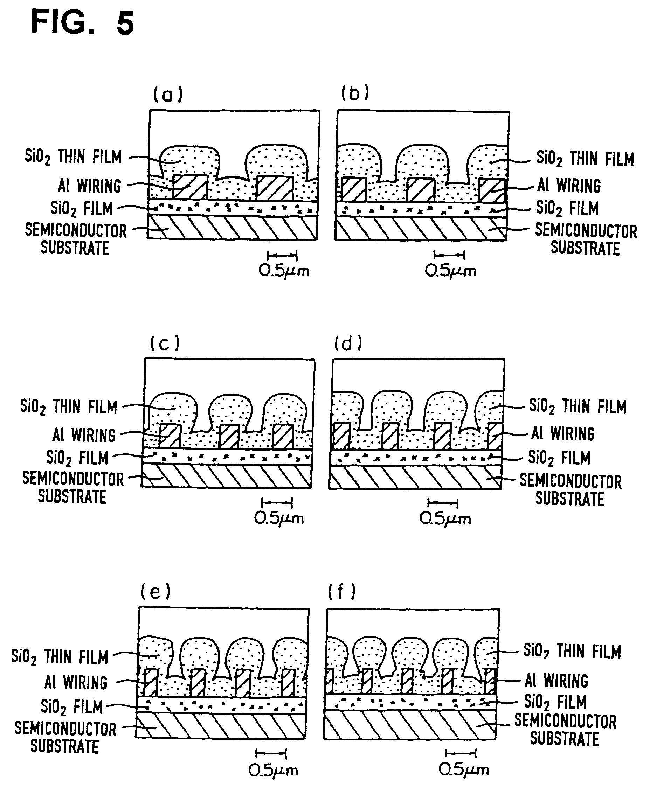

Figures 5(a)-(f) are longitudinal cross-sectional views illustrating the process of formation of a SiO₂ thin film, in which plasma is generated between a pair of electrodes set facing each other in the reaction container of said PECVD device by means of rf electrical power at 13.56 MHz, and SiH₄ reaction gas is fed into the reaction container so as to form a SiO₂ thin film on the SiO₂ oxide film formed on the surface of the semiconductor substrate and the Al wiring formed on its surface. These drawings were prepared by tracing the corresponding micrographs.

It can be seen from the aforementioned experimental results that for the SiO₂ thin film, the side surface has a convex round profile, and its head portion is wider than the bottom portion, so that the thin film profile corresponds to a poor embedding ability. Consequently, voids (gaps) may be formed in the vicinity of the bottom portion of the Al wiring. This is a disadvantage. In particular, this may lead to very serious problems in the case of submicron-size high-density wiring with a small gap between Al wiring portions (see Figures 5(e), (f)).

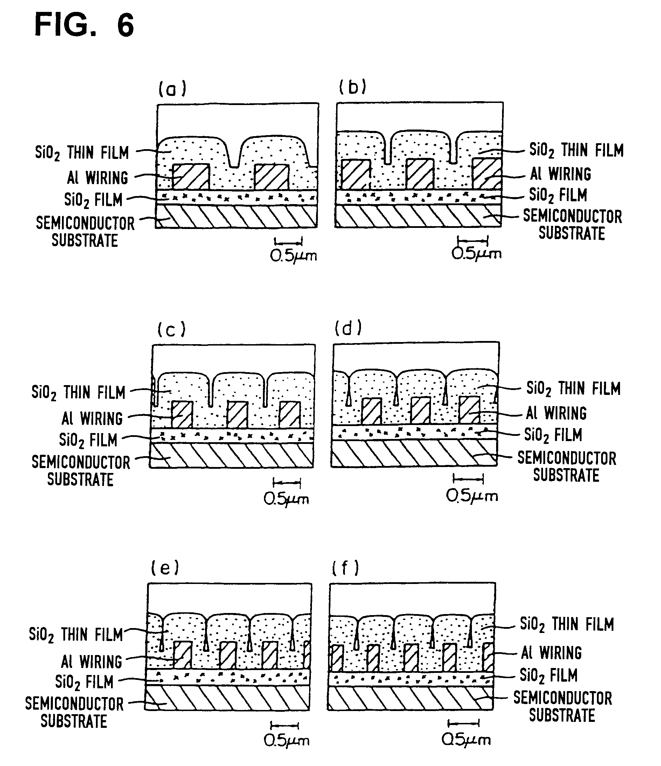

Figures 6(a)-(f) illustrate the experimental results (longitudinal cross-sectional views) in the process of formation of SiO₂ thin film as an insulating coating, in which a plasma is generated between a pair of electrodes set facing each other in the reaction container of said PECVD device by means of rf electrical power at 13.56 MHz, and TEOS gas is fed into the reaction container so as to form a SiO₂ thin film on the SiO₂ oxide film formed on the surface of the semiconductor substrate and the Al wiring formed on its surface. These drawings were also prepared by tracing the corresponding micrographs.

It can be seen from these experimental results that in the case illustrated in Figures 6(a)-(f), the side wall portion of the SiO₂ thin film formed does not have the roundness as that shown in Figures 5(a)-(f). As a result, it is possible to reduce the frequency of voids. Consequently, this technology makes a significant contribution to the control of the thin film formed.

That is, the conclusion is that the TEOS gas is preferred over the SiH₄ reaction gas for forming the high-density thin film.

However, as shown in Figures 6(e), (f), the embedding ability cannot be fully displayed when a thin film with even higher density is to be formed with gaps between the Al wiring portions reduced to submicron level. Consequently, reduction in the voids is insufficient, and it is thus difficult to meet the requirement on even higher density by simply using the TEOS gas.

In addition, in order to improve the thin film profile and embedding characteristics, there is an ambient-pressure CVD method in which O₃-TEOS gas is used. However, this manufacturing technology has the disadvantage that the oxide film formed has a high hygroscopicity. Consequently, it leads to degradation in the moisture resistance of the final product of the semiconductor IC device. This is a disadvantage.

In order to solve these problems, the present inventors have developed a thin film formation method which makes use of the TEOS gas and which can further reduce the frequency of voids. This thin film formation method has been disclosed in Japanese Patent Applications Nos. Sho 5(1993)-86366 and Sho 5(1993)-145070.

In this thin film formation method, in the PECVD method, a mixture of the TEOS gas and halogen gas (fluorine gas) or a mixture of the TEOS gas and halogen gas having saturated carbon skeleton is used as the reaction gas.

When this thin film formation method is used in manufacturing semiconductor IC devices with very high wiring density and element density, as the concave portions among the wiring and elements have the thin film well embedded, no void is formed, and the embedding characteristics are excellent. Also, as the side wall of the aforementioned thin film is very fine, the method has an excellent thin film quality control ability. Also, as fluorine is contained in the thin film, it is possible to form a thin film with a low dielectric constant, and it is possible to form a thin film with a very low hygroscopicity. That is, the thin film quality can be controlled easily. Consequently, it is possible to improve the electrical characteristics of the transistors, etc. formed. This is an advantage.

### Problems to be solved by the invention

However, although the thin film formation method disclosed in said Japanese Patent Applications Nos. Sho 5(1993)-86366 and Sho 5(1993)-145070 has the advantage that the embedding characteristics and fineness are excellent and the thin film formed has low dielectric constant and low hygroscopicity, the compressive stress of the thin film formed in this method is nevertheless lower than that in the thin film formed using the TEOS gas alone, as revealed in the later study.

As an example, for the thin film formed by means of pumping a reaction gas made of TEOS gas and C₂F₆ by means of plasma generated by an electrical power having two frequencies (thin film formed according to Japanese Patent Application No. Hei 5(1993)-86366), the compressive stress is about 2.0 x 10⁸ (dyne/cm²). On the other hand, for the thin film formed by means of pumping a reaction gas made of TEOS gas and C₂F₆ by means of a plasma generated by electrical power having a single frequency (thin film formed according to Japanese Patent Application No. Hei 5(1993)-145070), the compressive stress is about 3.4 x 10⁸ (dyne/cm²).

On the other hand, for the thin film formed by pumping the reaction gas made of TEOS gas alone by means of a plasma discharge energy with a single frequency, the compressive stress is about 1.1 x 10⁹ (dyne/cm²).

As can be seen from these experimental results, the compressive stress of the thin film formed according to Japanese Patent Applications No. Hei 5(1993)-86366 is about half the compressive stress of the thin film formed by using the TEOS gas alone. The compressive stress of the thin film formed according to Japanese Patent Application No. Hei 5(1993)-145070 is significantly lower than the compressive stress of the thin film formed using the TEOS gas alone. As a result, the thin films formed according to said Japanese Patent Application Nos. Hei 5(1993)-86366 and Hei 5(1993)-145070 to external electrical influence and mechanical force are weak. This is a disadvantage.

The purpose of this invention is to solve the aforementioned problems of the conventional methods by providing a type of thin film configuration and the thin film formation method characterized by the fact that it can increase the strength of (resistance of) the thin film to electrical influence and mechanical force without degrading the excellent effects of the conventional technology.

### Means for solving the problems

In order to realize the aforementioned purpose, this invention provides a type of thin film configuration characterized by the following facts:
there is a first formation layer, which is formed by means of chemical vapor deposition of a first reaction gas, with the first reaction gas made of TEOS gas only, or with the first reaction gas made of a mixture of the TEOS gas and a halogen gas, which is in a proportion smaller than that of the TEOS gas, and with the first reaction gas activated by means of a plasma discharge energy generated in a reaction container;
there is a second formation layer, which is formed by means of chemical vapor deposition of a second reaction gas, with the second reaction gas made of a mixture of TEOS gas and a halogen gas, which is in a proportion larger than that in said first reaction gas, and with the second reaction gas activated by means of plasma discharge energy generated in a reaction container; at least one of the aforementioned first and second formation layers is formed by coating on the sample surface, and at least one group of the aforementioned first and second formation layers are laminated to each other to form the desired semiconductor device.

On the other hand, this invention provides a thin film manufacturing method characterized by the following facts: it consists of the following stages of operation: a first stage of operation in which the plasma discharge energy generated in the reaction container is used to activate a first reaction gas, with the first reaction gas made of TEOS gas only, or with the first reaction gas made of a mixture of the TEOS gas and a halogen gas, which is in a proportion smaller than that of the TEOS gas, and the deposit formed by means of the chemical vapor deposition of the first reaction gas is used to form the first formation layer;
a second stage in which the plasma discharge energy generated in the reaction container is used to activate a second reaction gas, with the second reaction gas made of a mixture of the TEOS gas and a halogen gas, which is in a proportion larger than that in the aforementioned first reaction gas, and the deposit formed by means of the chemical vapor deposition of the second reaction gas is used to form the second formation layer;
either said first stage of operation or said second stage of operation may be implemented at first, and at least a group of said first formation layer and said second formation layer are sequentially laminated on the sample surface to form the laminate configuration of the thin film with two or more layers laminated on the sample surface.

The aforementioned halogen gas refers to any of the following gases: F₂, Cl₂, NF₃, SF₆, SiF₄, SiCl_{4,} ClF₃, BCl₃, HCl, HBr, HF, or any of the following halogen gases having a type of saturated carbon skeleton: CF₄, CHF₃, C₂F₆, CCl₄, CCl₂F₂, C₃F₈.

### Functions

For the thin film with the aforementioned configuration and formed using the aforementioned method, the configuration has a first formation layer with a high compressive stress and a second formation layer with a lower compressive stress yet to excellent embedding characteristics, low dielectric constant, and other excellent properties laminated with each other. Consequently, the disadvantages of the second formation layer (the disadvantage of a low compressive stress) can be compensated by the first formation layer. As a result, the thin film formed in this case has excellent embedding characteristics, excellent control of thin film thickness, low dielectric constant, high fineness, very low hygroscopicity, and excellent compressive stress. That is, this invention provides an effective technology in manufacturing high-density semiconductor device with excellent electrical characteristics and mechanical strength.

### Brief explanation of the figures

- Figure 1: is a schematic diagram illustrating the PECVD equipment used in an application example of this invention;
- Figure 2: is a longitudinal cross-sectional view illustrating the profile of the SiO₂ thin film formed by means of the PECVD device shown in Figure 1;
- Figure 3: is a schematic diagram illustrating the configuration of the PECVD equipment used in another application example of this invention;

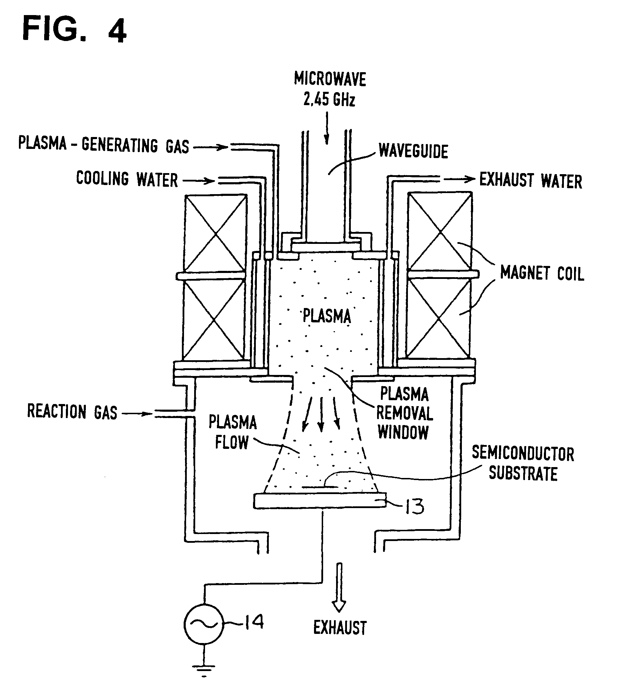

- Figure 4: is a diagram illustrating an application example of this invention used in an ECR plasma CVD equipment;
- Figure 5: is a longitudinal cross-sectional view illustrating the profile of the SiO₂ thin film formed using the conventional PECVD method; and
- Figure 6: is a longitudinal cross-sectional view illustrating the profile of another SiO₂ thin film formed using the conventional PECVD method.

### Application examples

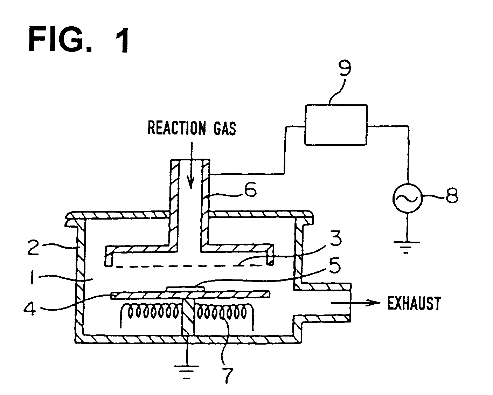

First of all, an application example of the thin film formation method of the semiconductor device in this invention will be explained with reference to figures. Figure 1 is a schematic diagram illustrating the PECVD apparatus used in this application example. A pair of electrodes 3, 4 facing each other are contained in an insulating reaction container 2 for realizing a reaction chamber 1 sealed off from the atmosphere. One electrode 4 is kept on the ground potential, and there is a sample 5 for forming the thin film (semiconductor substrate, etc.) set on its surface facing the other electrode. To the other electrode 3 is applied rf electrical power generated by rf oscillator 8 for generating plasma through an impedance matching circuit 9. The reaction gas is fed through pipeline 6 into reaction chamber 1 on the upper side of electrode 3, while the undesired portion of the reaction gas can be exhausted from one side of reaction container 2. Also, a heater 7 for controlling the temperature is arranged on the side of electrode 4. In addition, the frequency of the aforementioned rf electrical power is set at approximately 13.56 MHz.

In the following, the thin film manufacturing method using the PECVD apparatus with the aforementioned configuration will be explained. In the example to be explained, a SiO₂ oxide thin film is deposited on a semiconductor substrate; then, an Al wiring layer is formed on this oxide thin film to form a sample 5; on the rough surface of the sample, the thin film is formed.

First of all, in the first stage of operation, the PECVD method is used, and the TEOS gas alone is fed as the reaction gas into reaction chamber 1. By the plasma discharge energy generated between opposite electrodes 3, 4 by means of rf electrical power generated by rf oscillator 8, reaction gas (TEOS gas) is activated, and the first formation layer (SiO₂ layer) L1 is formed and coated on the sample surface of sample 5.

Then, in the second stage of operation, the PECVD method is applied in the same way as above, while a mixture of TEOS gas and halogen gas is fed as the reaction gas into reaction chamber 1. The plasma discharge energy generated between opposite electrodes 3, 4 due to rf electrical power from rf oscillator 8 activates the reaction gas (gas mixture), and a second formation layer L2 is formed and coated on said first formation layer L1.

In the aforementioned second stage of operation, the aforementioned halogen gas that can be used may be any one of the following gases: F₂, Cl₂, NF₃, SF_{6,} SiF₄, SiCl₄, ClF₃, BCl₃, HCl, HBr, HF, or any of the following halogen gases having a type of saturated carbon skeleton: CF₄, CHF₃, C₂F₆, CCl₄, CCl₂F₂, C₃F₈.

Then, in the third stage of operation, in the same way as in the first stage of operation, the TEOS gas alone is fed as the reaction gas into reaction chamber 1. By the plasma discharge energy generated between opposite electrodes 3, 4 by means of rf electrical power generated by rf oscillator 8, reaction gas (TEOS gas) is activated, and the third formation layer L3 is formed and coated on second formation layer L2. That is, third formation layer L3 has the same composition as that of first formation layer L1.

In this way, in this application example, the thin film formed has a 3-layer configuration made of formation layers L1, L2, L3.

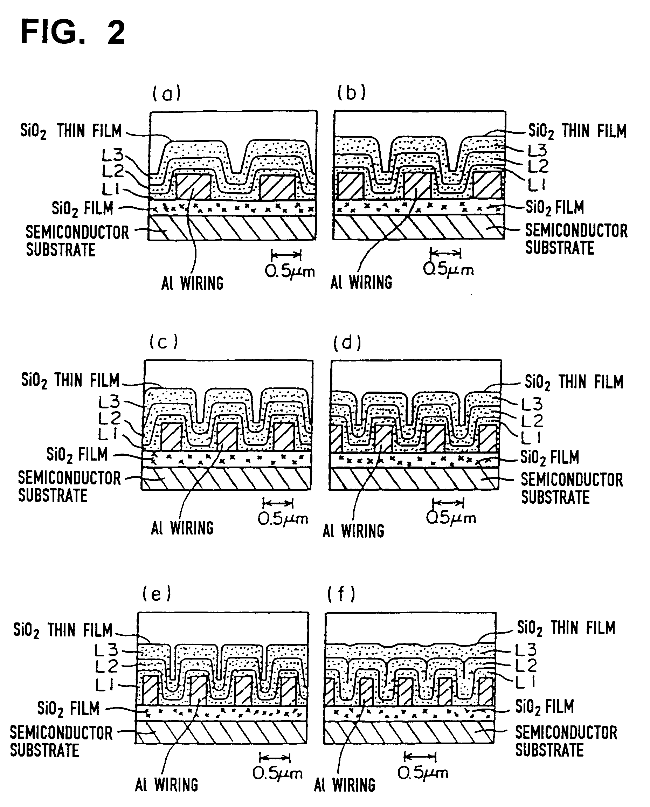

Figures 2(a)-(f) are longitudinal cross-sectional views of the thin film formed on sample 5. These cross-sectional views were prepared by tracing the longitudinal cross-sectional profiles of micrographs. The lengths in the longitudinal and lateral directions are represented by using the unit scale of 0.5 µm. The thickness of first formation layer L1 is about 1000 Å, the thickness of second formation layer L2 is about 7000 Å, the thickness of third formation layer L3 is about 5000 Å, and the overall thickness of the entire thin film is about 13000 Å.

As shown in Figures 2(a)-(d), when the width and gap of Al wiring pattern are relatively large, the side wall of the thin film is formed in taper profile, and formation of voids can be prevented.

On the other hand, as shown in Figure 2(e), even when the width and gap of the Al wiring pattern are in the submicron range, the side wall of the thin film is still flat, and the frequency of voids can be significantly decreased. As shown in Figure 2(f), when the width and gap of the Al wiring are further reduced in the submicron range, the thin film can still be embedded in the concave portion among the Al wiring portions, and the problem caused by voids can be solved completely. That is, there is an effect of formation of a thin film with excellent embedding characteristics. Also, as shown in Figures 2(a)-(e), the side wall of the thin film has a fine configuration and composition, the quality can be improved.

Consequently, it is believed that the effect that voids can be reduced and the side wall portion of the thin film can be formed in taper profile is due to the fact that in the second stage of operation, a mixture of the TEOS gas and halogen gas is used as the reaction gas and, as a result, while the deposit derived from the TEOS gas is formed, the deposit (the SiO₂ layer) can be etched isotopically by the halogen gas. As fluorine is contained in the thin film formed in this case, the dielectric constant is small, and it is possible to realize MOSFET with excellent electrical characteristics when the Al wiring is adopted as the inter-gate wiring for connecting among gate electrodes of MOSFET. Furthermore, even compared with the thin film formed using the ambient-pressure CVD method using the O₃-TEOS gas, which is able to form high-quality thin film, the thin film formed in this method has the same or better thin film forming property and embedding characteristics as well as a very low hygroscopicity.

In addition, second formation layer L2 is formed using the aforementioned gas mixture. Due to the 3-layer configuration with said second formation layer L2 sandwiched between first formation layer L1 and third formation layer L3, the strength of second formation layer L2 with a lower compressive stress can be compensated by first and third formation layers L1 and L3 with high compressive stress. Consequently, for the overall thin film, the electrical strength and the mechanical strength are high. Consequently, in this application example, the compressive stress of the thin film becomes about 5.80 x log (dyne/cm²), and the compressive stress is increased by more than twice as compared with the conventional thin film (the thin film shown in Figures 5 and 6).

As a result, in this application example, the thin film formed has excellent embedding characteristics, good thin film thickness, low dielectric constant, high fineness, very low hygroscopicity, and increased compressive stress. The effects are very good.

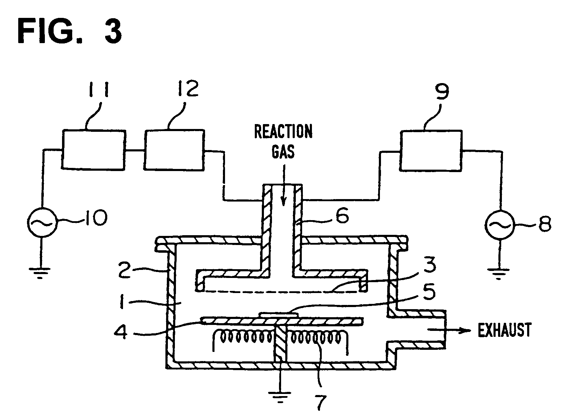

In the following, another application example will be explained. Figure 3 is a schematic diagram illustrating the PECVD equipment used in this application example. The PECVD equipment shown in Figure 3 differs from that shown in Figure 1 in that while the output of rf oscillator 8 in the PECVD equipment shown in Figure 1 is a rf electrical power having a single frequency for generating the plasma, in the PECVD equipment shown in Figure 3, a lower-frequency power source 11 and a high-cut filter circuit 12 are set in addition to rf oscillator 8, so that a power of lower-frequency power source 11 at a frequency lower than the frequency of rf oscillator 8 (by approximately 100 Hz) is fed to electrode 3 together with the rf power generated by rf oscillator 8 so as to generate the plasma. The remaining configuration is identical to that shown in Figure 1.

In the following, the thin film manufacturing method in the other application example will be explained. In the example to be explained, a SiO₂ oxide thin film is deposited on a semiconductor substrate; then, an Al wiring layer is formed on this oxide thin film to form a sample 5; on the rough surface of the sample, the thin film is formed.

First of all, in the first stage of operation, the PECVD method is used, and the TEOS gas alone is fed as the reaction gas into reaction chamber 1. By the plasma discharge energy generated between opposite electrodes 3, 4 by means of rf electrical power generated by rf oscillator 8, reaction gas (TEOS gas) is activated, and the first formation layer (SiO₂ layer) L1 is formed and coated on the sample surface of sample 5.

Then, in the second stage of operation, the PECVD method is applied in the same way as above, while a mixture of TEOS gas and halogen gas is fed as the reaction gas into reaction chamber 1.

The plasma discharge energy generated between opposite electrodes 3, 4 due to rf electrical power from rf oscillator 8 activates the reaction gas (gas mixture), and a second formation layer L2 is formed and coated on said first formation layer L1.

In the aforementioned second stage of operation, the aforementioned halogen gas that can be used may be any one of the following gases: F₂, Cl₂, NF₃, SF₆, SiF₄, SiCl₄, ClF₃, BCl₃, HCl, HBr, HF, or any of the following halogen gases having a type of saturated carbon skeleton: CF₄, CHF₃, C₂F₆, CCl₄, CCl₂F₂, C₃F₈.

Then, in the third stage of operation, in the same way as in the first stage of operation, the TEOS gas alone is fed as the reaction gas into reaction chamber 1. By the plasma discharge energy generated between opposite electrodes 3, 4 by means of a rf electrical power generated by rf oscillator 8, reaction gas (TEOS gas) is activated, and the third formation layer L3 is formed and coated on second formation layer L2. That is, third formation layer L3 has the same composition as that of first formation layer L1.

In this way, in this application example, the thin film formed has a 3-layer configuration made of formation layers L1, L2, L3.

Figures 2(a)-(f) are longitudinal cross-sectional views of the thin film formed in this way. The thin film formed in this way has excellent embedding characteristics, good thin film thickness controllability, low dielectric constant, high fineness, very low hygroscopicity, and increased compressive stress. That is, the characteristics of the thin film formed are excellent.

In said Application Example 2, as explained in the above, said second formation layer L2 is formed by means of a gas mixture, and a 3-layer thin film is formed with the first and third formation layers L1 and L3 are formed only by means of the TEOS gas. However, this invention is not limited to this 3-layer thin film. That is, the laminate configuration has at least one group of the combination of the formation layer made of the TEOS gas and the formation layer made of the gas mixture. For example, the 2-layer thin film which is formed by laminating a formation layer derived from the TEOS gas after formation of the formation layer by using the gas mixture, or the 2-layer thin film which is formed in a process opposite to the above process, namely by laminating a formation layer derived from the gas mixture after formation of a formation layer derived from the TEOS gas. Also, this invention is not limited to the aforementioned 2-layer and 3-layer configurations, configuration with more layers may also be adopted. The thicknesses of the various formation layers are determined appropriately in consideration of the target compressive stress of the thin film.

In the first and third stages of operation in said two application examples, the pure TEOS gas is used. However, the gas to be used in these stages is not limited to the pure TEOS gas. It is also possible to use a gas mixture prepared by adding a little halogen gas in the TEOS gas. It is possible to make use of the gas mixture with the mixing ratio controlled so that the compressive stress, the dielectric constant, and the hygroscopicity can be controlled.

In this way, by forming the thin film using a laminate of the formation layer (that is, the formation layer derived from the TEOS gas) with a high compressive stress and the formation layer with a lower compressive stress yet other excellent properties (that is, formation layer derived from a gas mixture), it is possible to display excellent control of forming the thin film with the prescribed compressive stress characteristics corresponding to the design specifications. Consequently, this technology is not a simple combination (of the existing technologies). As a result, it is possible to display an excellent effect in the development of the very large-scale IC (VLSI).

In the other aforementioned application example illustrated by Figure 3, the plasma is generated by means of electrical power having two frequencies, a higher frequency and a lower frequency. However, this invention is not limited to the aforementioned electrical power having two frequencies. It is also possible to generate the plasma by means of an electrical power having more than two different frequencies.

When this invention is adopted in an ECR plasma CVD apparatus, it is also possible to form the SiO₂ thin film in the same way as above. In this case, for example, as illustrated schematically in Figure 3, a microwave wave at 2.45 GHz is guided through a waveguide to the plasma generating chamber of the ECR plasma CVD equipment, while rf electrical power at 13.56 MHz generated by rf power source 14 is also applied on a semiconductor substrate for forming the thin film, and nitrogen (N₂) or other gas for generating the plasma is fed into the equipment. Then, the aforementioned gas mixture or TEOS gas as the reaction gas corresponding to the type of the formation layer to be formed is fed into the reaction chamber in sequence to form the desired thin film laminate configuration.

### Effects of the invention

As explained above, according to this invention, plasma discharge energy is generated in the reaction container by means of an electrical power having either single frequency or several different frequencies (that is, electrical power having two frequencies, with a higher frequency and a lower frequency, or electrical power having several frequencies); there is a first stage of operation in which the first reaction gas made of the TEOS gas alone or the first reaction gas made of a gas mixture of the TEOS gas and the halogen gas in a relatively small proportion is activated, and the deposit formed by means of the chemical vapor deposition of the first reaction gas is used to form the first formation layer; there is a second stage in which the plasma discharge energy generated by means of an electrical power having a single frequency or several different frequencies (that is, electrical power having two frequencies, with a higher frequency and a lower frequency, or electrical power having several frequencies) in the reaction container is used to activate a second reaction gas, with the second reaction gas made of a mixture of the TEOS gas and a halogen gas, which has a proportion larger than that in the aforementioned first reaction gas, and the deposit formed by means of the chemical vapor deposition of the second reaction gas is used to form the second formation layer; either said first stage of operation or said second stage of operation may be implemented at first, and at least a group of said first formation layer and said formation layer are sequentially laminated on the sample surface to form the laminate configuration of the thin film with two or more layers laminated on the sample surface. The obtained thin film has a laminate configuration containing said first formation layer having excellent compressive stress and said second formation layer with a lower compressive stress yet excellent embedding property, low dielectric constant, as well as other excellent functions. Consequently, the disadvantage of the second formation layer (that is, the disadvantage of a low compressive stress) can be compensated by the first formation layer.

Consequently, it is possible to realize a thin film with excellent embedding characteristics, excellent control of thin film thickness, low dielectric constant, high fineness, very low hygroscopicity, and excellent compressive stress. That is, this invention provides an effective technology in manufacturing a high-density semiconductor device with excellent electrical characteristics and mechanical strength.

### Symbols

- 1: reaction chamber
- 2: reaction container
- 3, 4: opposite electrodes
- 5: semiconductor substrate
- 6: pipeline
- 7: heater
- 8: rf power source
- 9, 11: impedance matching circuit
- 10: lower-frequency power source
- 12: high-cut filter circuit
- 13: electrode
- 14: rf power source
- L1: first formation layer
- L2: second formation layer
- L3: third formation layer

## Claims

1. A thin film of a semiconductor device **characterized** in
that it has the following laminate configuration:
there is a first formation layer (L1), which is formed by means of chemical vapor deposition of a first reaction gas, with the first reaction gas made of TEOS gas only, or with the first reaction gas made of a mixture of the TEOS gas and a halogen gas, which is in a proportion smaller than that of the TEOS gas, and with the first reaction gas activated by means of a plasma discharge energy generated in a reaction container (2);
there is a second formation layer (L2), which is formed by means of chemical vapor deposition of a second reaction gas, with the second reaction gas made of a mixture of TEOS gas and a halogen gas, which is in a proportion larger than that in said first reaction gas, and with the second reaction gas activated by means of plasma discharge energy generated in a reaction container (2);
at least one of the aforementioned first and second formation layers (L1, L2) is formed by coating on the sample surface, and at least one group of the aforementioned first and second formation layers are laminated to each other to form the desired semiconductor device.

2. The thin film of a semiconductor device according to claim 1,
**characterized** in
that it has the following laminate configuration:
the first layer coated on the aforementioned sample surface is made of the aforementioned first formation layer (L1);
the second layer laminated on the aforementioned first layer is made of the aforementioned second formation layer (L2); and
the third layer laminated on the aforementioned second layer is made of the aforementioned first formation layer (L1).

3. The thin film of a semiconductor device according to claim 1 or 2,
**characterized** in
that the aforementioned halogen gas refers to any of the following halogen gases: F₂, Cl₂, NF₃, SF₆, SiF₄, SiCl₄, ClF₃, BCl₃, HCl, HBr, HF, or any of the following halogen gases having a type of saturated carbon skeleton: CF₄, CHF₃, C₂F₆, CCl₄, CCl₂F₂, C₃F₈.

4. The thin film of a semiconductor device according to any of claims 1 to 3,
**characterized** in
that the aforementioned plasma discharge energy generated in the reaction container (2) is pumped by either electrical power with a single radio frequency or electrical power having several different frequencies.

5. A method of manufacturing a thin film of a semiconductor device,
**characterized** by
the following stages of operation:
a first stage of operation in which the plasma discharge energy generated in the reaction container (2) is used to activate a first reaction gas, with the first reaction gas made of TEOS gas only, or with the first reaction gas made of a mixture of the TEOS gas and a halogen gas, which is in a proportion smaller than that of the TEOS gas, and the deposit formed by means of the chemical vapor deposition of the first reaction gas is used to form the first formation layer (L1);
a second stage in which the plasma discharge energy generated in the reaction container (2) is used to activate a second reaction gas, with the second reaction gas made of a mixture of the TEOS gas and a halogen gas, which has a proportion larger than that in the aforementioned first reaction gas, and the deposit formed by means of the chemical vapor deposition of the second reaction gas is used to form the second formation layer (L2);
either said first stage of operation or said second stage of operation may be implemented at first, and at least a group of said first formation layer (L1) and said second formation layer (L2) are sequentially laminated on the sample surface to form the laminate configuration of the thin film with two or more layers laminated on the sample surface.

6. The method according to claim 5,
**characterized** in
that the aforementioned thin film with a laminate configuration is formed as follows:
the aforementioned first stage of operation is performed to form the first layer made of the aforementioned first formation layer (L1) on the aforementioned sample surface;
then, the aforementioned second stage of operation is performed to form the second layer made of the aforementioned second formation layer (L2) on the aforementioned first layer; and
then the aforementioned first stage of operation is performed to form the third layer made of the aforementioned first formation layer (L1) on the aforementioned second layer.

7. The method according to claim 5 or 6,
**characterized** in
that the aforementioned halogen gas refers to any of the following halogen gases: F₂, Cl₂, NF₃, SF₆, SiF₄, SiCl₄, ClF₃, BCl₃, HCl, HBr, HF, or any of the following halogen gases having a type of saturated carbon skeleton: CF₄, CHF₃, C₂F₆, CCl₄, CCl₂F₂, C₃F₈.

8. The method according to any of claims 5 to 7,
**characterized** in
that the aforementioned plasma discharge energy generated in the reaction container (2) is pumped by either electrical power with a single radio frequency or electrical power having several different frequencies.
